Europäisches Patentamt

European Patent Office

Office européen des brevets

(19)

(11) **EP 1 040 492 B1**

(12) **FASCICULE DE BREVET EUROPEEN**

(45) Date de publication et mention
de la délivrance du brevet:
**20.03.2002 Bulletin 2002/12**

(51) Int Cl.⁷: **H01H 1/00**

(21) Numéro de dépôt: **98959979.0**

(22) Date de dépôt: **14.12.1998**

(86) Numéro de dépôt international:
**PCT/FR98/02719**

(87) Numéro de publication internationale:
**WO 99/31689 (24.06.1999 Gazette 1999/25)**

(54) **MICROSYSTEME A ELEMENT DEFORMABLE SOUS L'EFFET D'UN ACTIONNEUR THERMIQUE**

MIKROSTRUKTUR MIT EINEM VERFORMBAREN ELEMENT DURCH EINWIRKUNG EINES THERMISCHEN ANTRIEBES

MICROSYSTEM WITH ELEMENT DEFORMABLE BY THE ACTION OF A HEAT-ACTUATED DEVICE

(84) Etats contractants désignés:
**DE GB IT**

(30) Priorité: **16.12.1997 FR 9715931**

(43) Date de publication de la demande:
**04.10.2000 Bulletin 2000/40**

(73) Titulaire: **COMMISSARIAT A L'ENERGIE ATOMIQUE**
**75015 Paris (FR)**

(72) Inventeur: **FOUILLET, Yves**
**F-38340 Le Chevalon de Voreppe (FR)**

(74) Mandataire: **Weber, Etienne Nicolas et al**
**c/o Brevatome,**
**3, rue du Docteur Lancereaux**
**75008 Paris (FR)**

(56) Documents cités:
EP-A- 0 709 911          DE-A- 19 516 997
US-A- 5 681 024

• HIROTSUGU MATOBA ET AL: "A BISTABLE SNAPPING MICROACTUATOR" PROCEEDING OF THE WORKSHOP ON MICRO ELECTRO MECHANICAL SYSTEMS (MEM, OISO, JAN. 25 - 28, 1994, no. WORKSHOP 7, 25 janvier 1994, pages 45-50, XP000528391 INSTITUTE OF ELECTRICAL AND ELECTRONICS ENGINEERS
• PATENT ABSTRACTS OF JAPAN vol. 095, no. 003, 28 avril 1995 & JP 06 338244 A (SHARP CORP), 6 décembre 1994
• MEHREGANY M: "MICROELECTROMECHANICAL SYSTEMS" IEEE CIRCUITS AND DEVICES MAGAZINE, vol. 9, no. 4, 1 juillet 1993, pages 14-22, XP000441757

## Description

### Domaine technique

La présente invention concerne un microsystème selon le préambule de la revendication 1, comme il est connu par example du document US-A-5 463 233. Parmi les applications de tels microsystèmes on peut citer les micro-rupteurs destinés à ouvrir ou à fermer un circuit électrique et les micro-valves destinées à des applications microfluidiques.

Ces microsystèmes comportent un élément, en forme de poutre ou de membrane, déformable sous l'effet de la chaleur. Un comportement fortement non linéaire est recherché afin d'obtenir un basculement rapide entre deux états, un état ouvert et un état fermé.

Ces microsystèmes doivent pouvoir être conçus pour être éventuellement compatibles avec la réalisation de composants micro-électroniques.

### Etat de la technique antérieure

On peut classer les micro-actionneurs utilisés pour provoquer la déformation de l'élément déformable du microsystème selon trois catégories principales en fonction des principes mis en oeuvre. On trouve d'abord les actionneurs thermiques qui utilisent la dilatation thermique d'un ou de plusieurs éléments constitutifs. On trouve ensuite les actionneurs électrostatiques qui utilisent la force électrostatique générée entre deux éléments de charges différentes. On trouve enfin les actionneurs magnétiques qui utilisent des forces induites par un champ magnétique.

Il existe cependant aussi des actionneurs utilisant des matériaux piézoélectriques et magnétostrictifs.

Les actionneurs thermiques semblent les plus intéressants car ils permettent généralement de plus grandes déformations que les actionneurs électrostatiques tandis que les actionneurs magnétiques, ou ceux utilisant des matériaux piézoélectriques ou magnétostrictifs, sont généralement difficiles à mettre en oeuvre par les procédés classiques du micro-usinage, notamment pour les réalisations nécessitant la compatibilité technologique avec la micro-électronique. De plus, avec un actionneur thermique, il est facile de généraliser l'utilisation d'un micro-rupteur commandé à un micro-rupteur thermique (changement d'état à partir d'une température critique), ou à un micro-disjoncteur (changement d'état à partir d'une intensité de courant critique).

La manière la plus simple pour réaliser un actionneur thermique est d'utiliser un bilame. Ce dernier est constitué de deux couches de matériaux ayant des coefficients de dilatation thermique différents de manière qu'une variation de température de l'ensemble entraîne une déflexion du bilame. L'élévation de température est obtenue par effet Joule en faisant passer soit directement un courant électrique dans l'une des deux couches constituant le bilame, soit en faisant passer un courant électrique dans des résistances formées sur l'une de ces couches et obtenues, par exemple, par implantation si l'une des couches est en silicium.

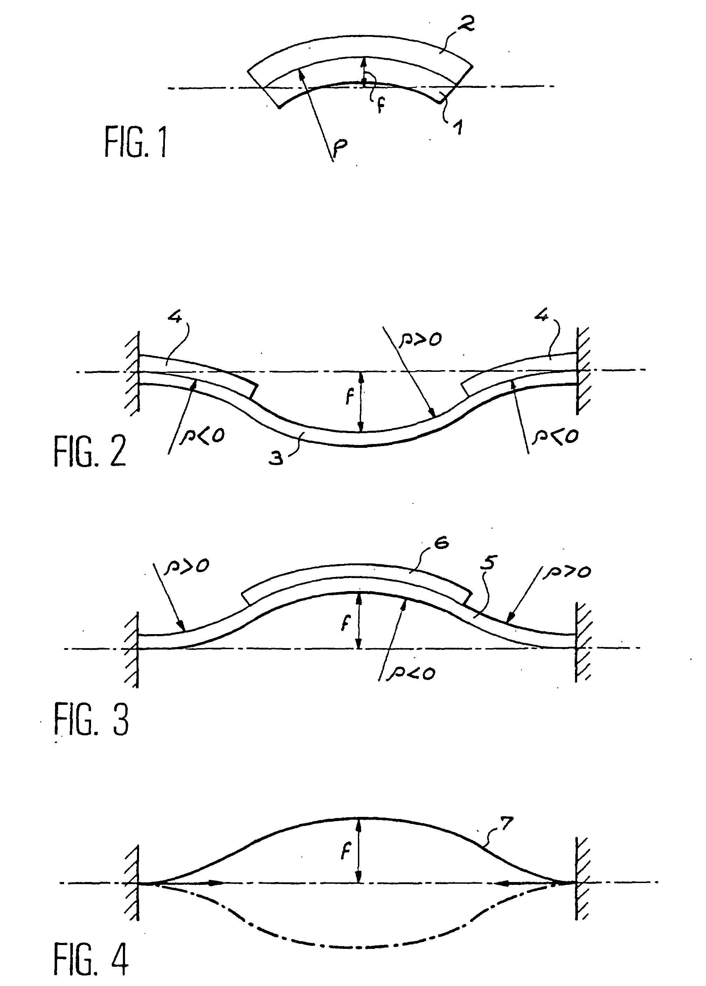

La déformation d'un bilame dépend de son type de fixation sur son support. La figure 1 montre la déformation, sous l'effet d'une contrainte thermique d'un bilame libre, c'est-à-dire aux extrémités non fixées mais simplement supportées, constitué d'une couche 1 et d'une couche 2 présentant des coefficients de dilatation thermique différents. Le trait mixte montre la position moyenne du bilame en l'absence d'une contrainte thermique. La théorie montre que, dans ce cas, le rayon de courbure $\rho$ est uniforme. Il est négatif si le coefficient de dilatation de la couche 2 est plus grand que celui de la couche 1.

Si la structure déformable est encastrée à ses extrémités, il est préférable, en raison de l'allure de la déformée de localiser le bilame dans les zones ou l'effet de dilatation agit dans le sens de la courbure. Suivant la localisation du bilame, une augmentation de température peut défléchir la structure dans un sens ou dans l'autre sens.

La figure 2 montre une première structure bilame de cette sorte. Elle comprend une première couche 3 et une deuxième couche 4 formée de deux portions. Le trait mixte indique la position moyenne du bilame en l'absence d'une contrainte thermique. Le coefficient de dilatation thermique de la couche 4 étant plus grand que celui de la couche 3, la déformation de la structure bilame sous l'effet d'une dilatation se fait dans le sens indiqué sur la figure 2.

La figure 3 montre une deuxième structure bilame encastrée à ses extrémités. Elle comprend une première couche 5, qui est effectivement encastrée, et une deuxième couche 6 qui est située sur la partie centrale de la couche 5. Le trait mixte indique la position moyenne du bilame en l'absence d'une contrainte thermique. Le coefficient de dilatation thermique de la couche 6 étant plus grand que celui de la couche 5, la déformation de la structure bilame sous l'effet d'une dilatation se fait dans le sens indiqué sur la figure 3.

On montre aussi que l'amplitude f de la déformée est proportionnelle à la température et donc que la déformée dépend de la température ambiante. Il est possible cependant de trouver des configurations de structure permettant d'obtenir que la déformée reste indépendante de la température ambiante.

Cependant, en raison des mécanismes complexes mis en jeu lors de l'ouverture et de la fermeture d'un circuit électrique (phénomènes d'arc électrique, de rebond, etc.), il est préférable de rechercher des systèmes pour lesquels le changement d'état (le passage de l'état d'ouverture du circuit à son état de fermeture) soit le plus rapide possible. L'idéal serait de concevoir des systèmes ayant une température critique au delà de laquelle on change d'état d'équilibre mécanique. Ceci ne peut cependant pas être obtenu simplement par un bilame.

Le brevet US-A-5 463 233 divulgue un interrupteur thermique micro-usiné combinant un bilame et un actionneur électrostatique. En l'absence de déformation du bilame, la force électrostatique est faible, le bilame est en équilibre entre la force électrostatique et la force de rappel mécanique de la structure. Quand la température augmente, l'effet bilame rapproche les électrodes de l'actionneur jusqu'à ce que la force électrostatique devienne suffisamment forte pour vaincre la force de rappel mécanique et provoquer ainsi le basculement instantané de la structure.

Une autre manière de générer un déplacement par changement de température consiste à chauffer une poutre ou une membrane encastrée. Le figure 4 montre une membrane 7 encastrée, située en position de repos selon le trait mixte et en position déformée selon le trait plein. La dilatation thermique a pour effet de mettre la structure en compression. La théorie des poutres ou des membranes montre qu'il existe une contrainte de compression (donc une température) critique au delà de laquelle la structure est en flambage. L'article "Buckled Membranes for Microstructures" de D.S. Popescu et al., paru dans la revue IEEE, pages 188-192 (1994), décrit une telle structure mise en compression. Dans le cas d'une poutre d'épaisseur h, de longueur L, réalisée avec un matériau ayant un coefficient de dilatation $\alpha$, la contrainte de compression critique est donnée par la relation :

$$\theta_{cr} = \frac{\pi^2 h^2}{3\alpha L^2} \qquad (1)$$

La théorie montre aussi que l'amplitude f de la déformée de la structure est donnée par la relation :

$$f = \pm \sqrt{\frac{\theta}{\theta_{cr}} - 1} \qquad (2)$$

Dans le cas d'une membrane carrée, A vaut 2,298 h. L'un des inconvénients de cette méthode réside dans l'indétermination du signe de f. Comme le montre la figure 4, la membrane 7 peut très bien se déformer dans le sens opposé et prendre la position indiquée par la ligne de trait interrompu. On constate aussi d'après la relation (2) qu'il est difficile d'obtenir de grandes amplitudes de déplacement pour des structures réalisées par des technologies de surface, c'est-à-dire en couches minces.

Une autre solution dérivée de la précédente consiste à utiliser une membrane naturellement en flambage. Ceci est par exemple obtenu en utilisant des membranes en oxyde de silicium. Le système a donc deux positions stables

$$f = \pm A \sqrt{\frac{S}{S_{cr}} - 1},$$

ou S est la contrainte interne et $S_{cr}$ est la contrainte critique de flambage. Pour basculer d'une position à une autre il est nécessaire d'ajouter une action mécanique supplémentaire. Dans l'article cité plus haut de D.S. Popescu et al., cette action mécanique supplémentaire est constituée par un champ de pression sur la membrane.

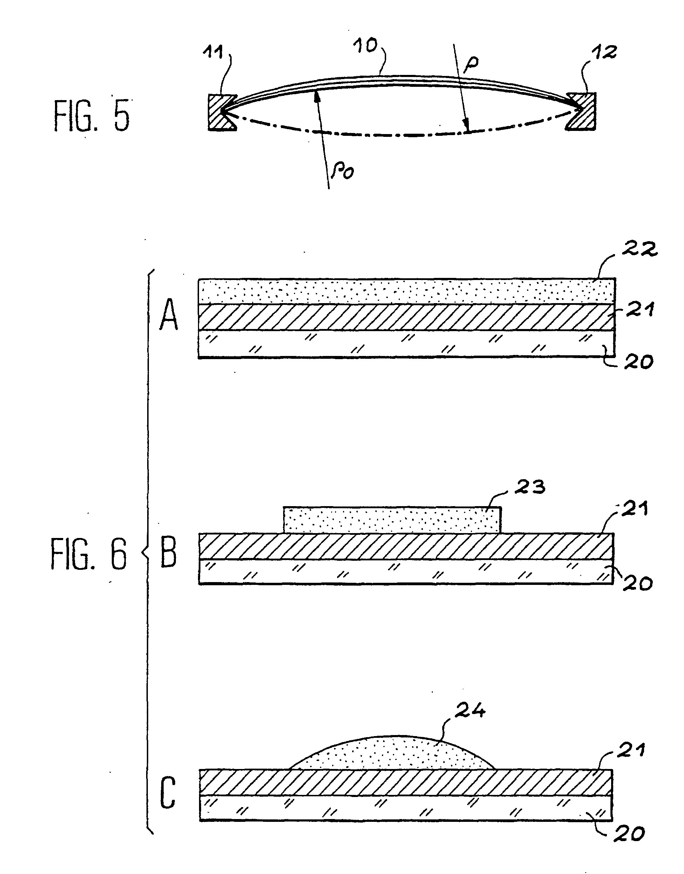

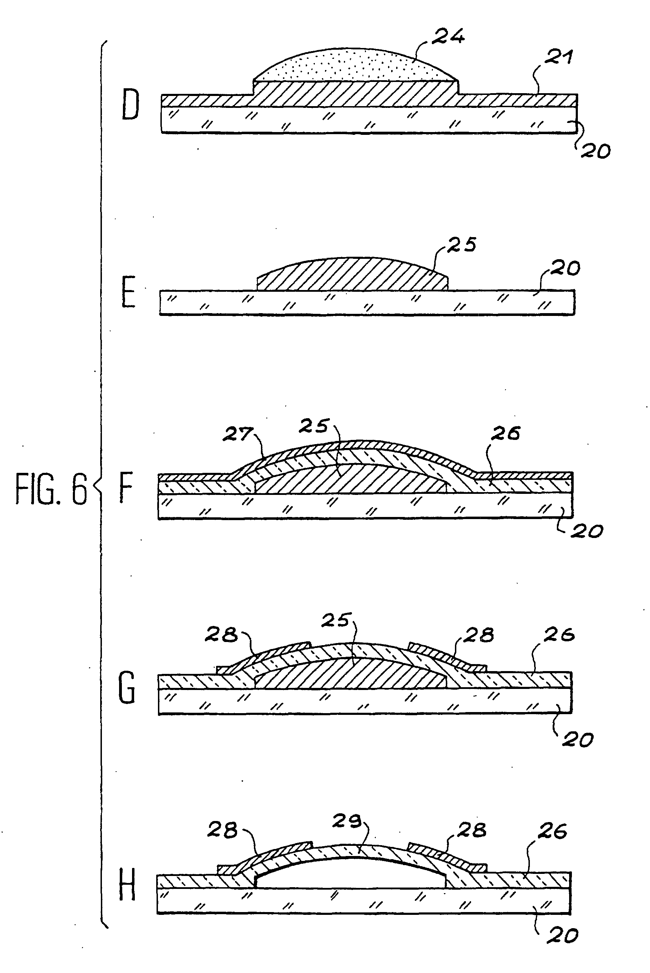

Le bilame encastré a été étudié dans l'article "Analysis of Mi-metal Thermostats" de TIMOSHENKO paru dans la revue Journal of the Optical Society of America, vol. 11, pages 233-255, 1925. Cet article donne notamment une étude théorique de la structure représentée à la figure 5. La structure déformable est une poutre 10 constituée d'un bilame dont les extrémités sont retenues par deux supports fixes 11 et 12. La rétention des extrémités supprime les degrés de liberté en translation mais laisse libre le degré de liberté en rotation suivant un axe perpendiculaire au plan de la figure. Au repos, c'est-à-dire à une température telle qu'il n'y a pas de contrainte thermique dues à l'effet bilame, la poutre, représentée en traits pleins sur la figure 5, présente une déformée initiale en arc de cercle de rayon $\rho_o$. Lorsque la température augmente, les effets suivants se produisent :

- 1er effet : la dilatation thermique longitudinale de la poutre étant bloquée par les supports 11 et 12, la poutre est soumise à une contrainte de compression.
- 2ème effet : le bilame est réalisé de manière qu'une augmentation de la température entraîne une augmentation de la courbure. Ceci se traduit par une déflexion de la poutre vers le bas sur la figure 5,
- 3ème effet : en raison de l'effet précédent, la longueur de la poutre diminue. Ceci induit une contrainte interne supplémentaire de compression dans la poutre.

Les premier et troisième effets favorisent le flambage de la structure, ce qui provoque le basculement de la poutre à partir d'une température critique. La poutre prend alors la position indiquée en traits interrompus sur la figure 5.

Les systèmes de l'art antérieur étudiés ci-dessus présentent des caractéristiques telles qu'ils ne permettent pas d'obtenir un micro-actionneur pour défléchir une membrane ou une poutre en utilisant les effets de dilatation thermique avec les avantages suivants :

- une non-linéarité entre température et déflexion de manière à avoir un changement brutal (basculement et notion de température critique) avec une amplitude importante ;
- pas d'autre actionneur que celui procurant l'effet de dilatation thermique ;

- l'utilisation d'une technique de réalisation en couche mince, ce qui oblige à avoir des encastrements rigides pour l'élément déformable.

## Exposé de l'invention

Pour remédier aux inconvénients cités ci-dessus, on propose un microsystème dont l'élément déformable (poutre ou membrane) est, au repos, naturellement défléchie, cette déflexion initiale n'étant pas du type flambage. L'élément déformable présente donc une forme non plane, prédéfinie par construction. Cet élément déformable est encastré et la déformation provoquée par un actionneur thermique résulte d'un effet bilame et d'un phénomène de flambage induit par la dilatation thermique. A l'état de repos, l'encastrement n'exerce pas de contrainte sur l'élément déformable.

L'invention a donc pour objet un microsystème constitué sur un substrat et servant à obtenir un basculement entre un premier état de fonctionnement et un deuxième état de fonctionnement grâce à un actionneur thermique à effet bilame, ledit actionneur comprenant un élément déformable rattaché, par des extrémités opposées, au substrat de façon à présenter naturellement une déflexion sans contrainte par rapport à une surface du substrat qui lui est opposée, cette déflexion naturelle déterminant ledit premier état de fonctionnement, ledit deuxième état de fonctionnement étant provoqué par ledit actionneur thermique qui induit, sous l'effet d'une variation de température, une déformation de l'élément déformable tendant à diminuer sa déflexion et le soumettant à une contrainte de compression qui entraine son basculement par effet de flambage dans une direction opposée à sa déflexion naturelle. Lorsque la commande thermique provoquée par l'actionneur est supprimée, le microsystème revient à son premier état de fonctionnement.

Le premier état de fonctionnement peut correspondre à une position de l'élément déformable la plus éloignée de ladite surface du substrat, ledit deuxième état de fonctionnemenet correspondant à une position de l'élément déformable la plus proche de ladite surface du substrat. La situation inverse est également possible.

La partie centrale de l'élément déformable peut être plus épaisse que sa partie périphérique.

L'invention a aussi pour objet un micro-rupteur constitué d'un microsystème tel que défini ci-dessus, un système d'électrodes étant prévu dans le microsystème, sur la surface du substrat et sur l'élément déformable, de façon à présenter une continuité électrique entre électrodes dans l'un desdits états de fonctionnement et une absence de continuité électrique dans l'autre desdits états de fonctionnement.

L'invention a aussi pour objet une micro-valve constituée d'un microsystème tel que défini ci-dessus, un orifice de communication de fluide étant prévu dans le microsystème de façon à être obturé dans l'un desdits états de fonctionnement et ouvert dans l'autre desdits états de fonctionnement.

L'invention a aussi pour objet un procédé de fabrication d'un microsystème tel que défini ci-dessus, caractérisé en ce que :

- l'élément déformable est obtenu par dépôt d'une couche de matériau approprié sur ladite surface du substrat, la couche étant solidaire de ladite surface à l'exception d'une partie formant voûte au-dessus de ladite surface et constituant l'élément déformable,
- des moyens, obtenus par dépôt, sont prévus pour être en contact intime avec ledit élément déformable et constituer avec celui-ci ledit actionneur thermique à effet bilame.

Avantageusement, la partie formant voûte est obtenue grâce au dépôt préalable, sur ladite surface du substrat, d'une masse sacrificielle destinée à donner une forme définie audit élément déformable une fois que la masse sacrificielle aura été sacrifiée, la masse sacrificielle étant prévue pour que, à l'issue du procédé, ledit élément déformable présente naturellement une déflexion sans contrainte par rapport à ladite surface du substrat.

Selon une première variante, le procédé comprend les étapes successives suivantes :

- dépôt sur ladite surface du substrat d'une couche de matériau sacrificiel,
- obtention sur la couche de matériau sacrificiel, d'une masse d'un matériau susceptible de fluer sans altérer le substrat et le matériau sacrificiel,
- fluage du matériau susceptible de fluer pour lui conférer une forme complémentaire de la forme en voûte désirée pour l'élément déformable,
- gravure de la couche de matériau sacrificiel et du matériau qui a flué jusqu'à ne garder sur ladite surface du substrat que ladite masse sacrificielle qui reproduit la forme que possédait le matériau qui a flué,
- dépôt de la couche destinée à fournir l'élément déformable,
- dépôt des moyens destinés à constituer, avec ledit élément déformable, ledit actionneur thermique,
- élimination de la masse sacrificielle.

Dans ce cas, la masse de matériau susceptible de fluer peut être obtenue par dépôt d'une couche de résine photosensible sur la couche de matériau sacrificiel et par gravure de cette couche de résine photosensible pour n'en garder que ladite masse de matériau susceptible de fluer.

Selon une deuxième variante, le procédé comprend les étapes successives suivantes :

- obtention sur ladite surface du substrat d'une masse sacrificielle, à profil en escalier, et de forme sensiblement complémentaire de la forme en voûte désirée pour l'élément dèformable,

- dépôt de la couche destinée à fournir l'élément déformable,

- dépôt des moyens destinés à constituer, avec ledit élément déformable, ledit actionneur thermique,

- élimination de la masse sacrificielle.

Dans ce cas, la masse sacrificielle peut être obtenue par dépôt sur ladite surface du substrat d'une couche de matériau sacrificiel et gravures successives de cette couche de matériau sacrificiel jusqu'à atteindre la surface du substrat à l'exception de l'emplacement de l'élément déformable où les gravures laissent subsister ladite masse sacrificielle.

Selon une troisième variante, le procédé comprend les étapes successives suivantes :

- obtention sur ladite surface du substrat d'une masse de matériau sacrificiel d'épaisseur uniforme à l'emplacement de l'élément déformable,

- dépôt de la couche destinée à fournir l'élément déformable, le dépôt étant réalisé de façon que la partie de cette couche recouvrant la masse de matériau sacrificiel soit naturellement contrainte,

- dépôt, sur la couche précédemment déposée, d'une couche dans laquelle seront formés les moyens destinés à constituer, avec ledit élément déformable, ledit actionneur thermique, ce dépôt étant réalisé à une température déterminée pour que, à l'issue du procédé, l'élément déformable soit naturellement défléchi,

- gravure de la couche précédemment déposée pour former les moyens destinés à constituer, avec ledit élément déformable, ledit actionneur thermique,

- élimination de la masse sacrificielle.

Dans ce cas, la masse sacrificielle peut être obtenue par dépôt sur ladite surface du substrat d'une couche de matériau sacrificiel et gravure de cette couche de matériau sacrificiel.

Quel que soit le procédé mis en oeuvre, il peut être nécessaire de prévoir une étape consistant à ouvrir l'élément déformable de façon que cette ouverture de l'élément déformable permette d'éliminer la masse sacrificielle.

**Brève description des dessins**

L'invention sera mieux comprise au moyen de la description qui va suivre, donnée à titre d'exemple non limitatif, accompagnée des dessins annexés parmi lesquels :

- les figures 1 à 5, déjà décrites, représentent des dispositifs à élément déformable sous l'effet d'un actionneur thermique,

- les figures 6A à 6H sont illustratives d'une première variante d'un procédé de fabrication d'un microsystème à élément déformable sous l'effet d'un actionneur thermique selon la présente invention,

- les figures 7A à 7D sont illustratives d'une deuxième variante d'un procédé de fabrication d'un microsystème à élément déformable sous l'effet d'un actionneur thermique selon la présente invention,

- les figures 8A à 8D sont illustratives d'une troisième variante d'un procédé de fabrication d'un microsystème à élément déformable sous l'effet d'un actionneur thermique selon la présente invention,

- la figure 9 représente, vu en coupe, un micro-rupteur selon la présente invention à l'état ouvert,

- la figure 10 représente, vu en coupe, un autre micro-rupteur selon la présente invention à l'état fermé,

- la figure 11 représente, vu en coupe, encore un autre micro-rupteur selon la présente invention à l'état ouvert,

- la figure 12 représente, vue en coupe, une microvalve selon la présente invention à l'état ouvert.

**Description détaillée de modes de réalisation de l'invention**

Généralement, les structures obtenues par des procédés de la microtechnologie ont une géométrie plane, aussi la réalisation de poutres ou de membranes naturellement défléchies nécessite une attention particulière.

Les procédés qui vont maintenant être décrits mettent en oeuvre le dépôt de l'élément déformable sur une couche, dite couche sacrificielle, que l'on élimine en fin de procédé. On peut ainsi avoir un élément déformable, poutre ou membrane, en $Si_3N_4$ en utilisant une couche sacrificielle en tungstène.

Une première variante du procédé selon l'invention, illustrée par les figures 6A à 6H, permet d'obtenir un microsystème à élément déformable (poutre ou membrane) non plan et non contraint. Sur un substrat 20, par exemple en verre, on dépose d'abord une couche sacrificielle 21, par exemple en tungstène, puis une couche de résine photosensible 22 (figure 6A). La couche de résine est gravée pour ne laisser qu'une masse de résine 23 dont la superficie est déterminée par l'élément déformable désiré (figure 6B). Par un traitement thermique, on provoque le fluage de la résine photosensible. On obtient une masse 24 dont la forme est complémentaire de la forme en voûte désirée pour l'élément déformable (figure 6C).

La couche sacrificielle 21 est ensuite gravée. La figure 6D montre une première étape de gravure où la couche sacrificielle 21 est gravée sur une partie de son épaisseur aux endroits où cette couche n'est pas masquée par la masse 24 de résine. La figure 6E montre une deuxième étape de gravure où la masse 24 de résine a été éliminée, par exemple par gravure ionique réactive. La couche sacrificielle a simultanément été gravée en reproduisant la forme de la masse 24 de la figure 6D. On obtient une masse 25 de matériau sacrificiel.

On pourrait obtenir directement la masse sacrificielle telle que montrée sur la figure 6E en utilisant un matériau organique (par exemple un polyimide) à condition que ce matériau puisse fluer tout en supportant sans dégradation les étapes de fabrication de l'élément déformable.

On recouvre ensuite la surface du substrat 20 supportant la masse sacrificielle 25 d'abord d'une couche 26, par exemple en $Si_3N_4$ ou en silicium, puis d'une couche 27 en matériau conducteur tel que l'aluminium, l'or, le nickel (voir la figure 6F). Les matériaux des couches 25 et 26 doivent avoir des coefficients de dilatation thermique différents tout en restant compatible avec l'étape postérieure de libération de l'élément déformable.

La couche 27 est ensuite gravée (voir la figure 6G) pour y délimiter des parties 28 de l'actionneur thermique.

La couche 26 est également gravée. Cette gravure est déterminée en fonction de la forme que l'on désire donner à l'élément déformable (poutre ou membrane). Elle permet également d'ouvrir l'élément déformable afin de permettre l'élimination de la masse sacrificielle 25.

On obtient alors le microsystème illustré par la figure 6H possédant un élément déformable 29 naturellement défléchi par rapport à la surface du substrat 20.

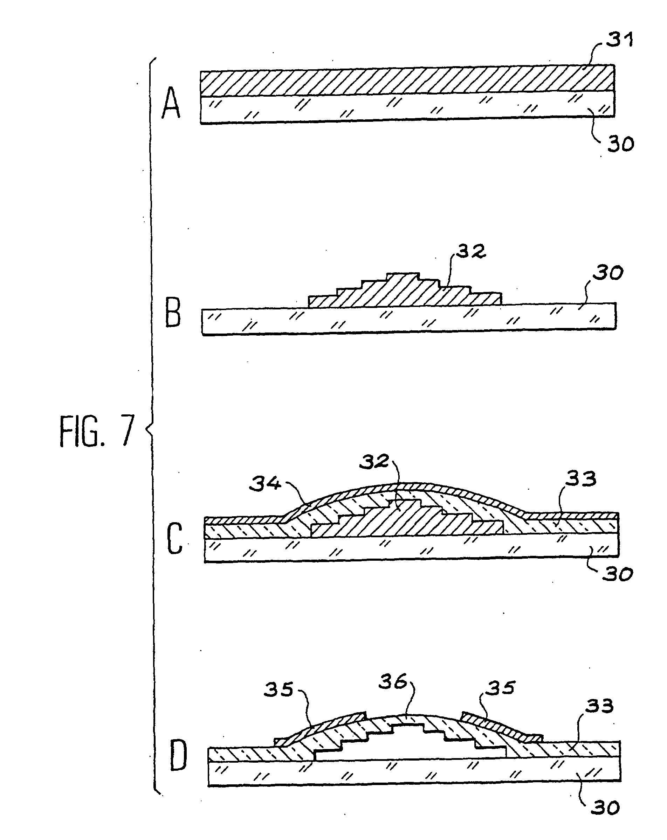

Une deuxième variante du procédé selon l'invention, illustrée par les figures 7A à 7D, permet également d'obtenir un microsystème à élément déformable non plan et non contraint. Sur une surface d'un substrat 30, on dépose une couche sacrificielle 31 (voir la figure 7A). Cette couche sacrificielle est gravée à plusieurs reprises et avec autant de masques jusqu'à obtenir une masse sacrificielle 32, à profil en escalier, et de forme sensiblement complémentaire de la forme en voûte désirée pour l'élément déformable. Autour de la masse sacrificielle 32, la surface du substrat est apparente (voir la figure 7B). On dépose ensuite, comme précédemment, une couche 33 et une couche 34 destinées à constituer l'élément déformable et l'actionneur thermique.

Comme précédemment, la couche 34 est gravée pour obtenir des parties 35. De même, la couche 33 est gravée en fonction de la forme que l'on désire donner à l'élément déformable et pour ouvrir cet élément déformable afin de permettre l'élimination de la masse sacrificielle 32.

On obtient le microsystème illustré par la figure 7D possédant un élément déformable 36 naturellement défléchi par rapport à la surface du substrat 30. Les matériaux utilisés peuvent être les mêmes que précédemment.

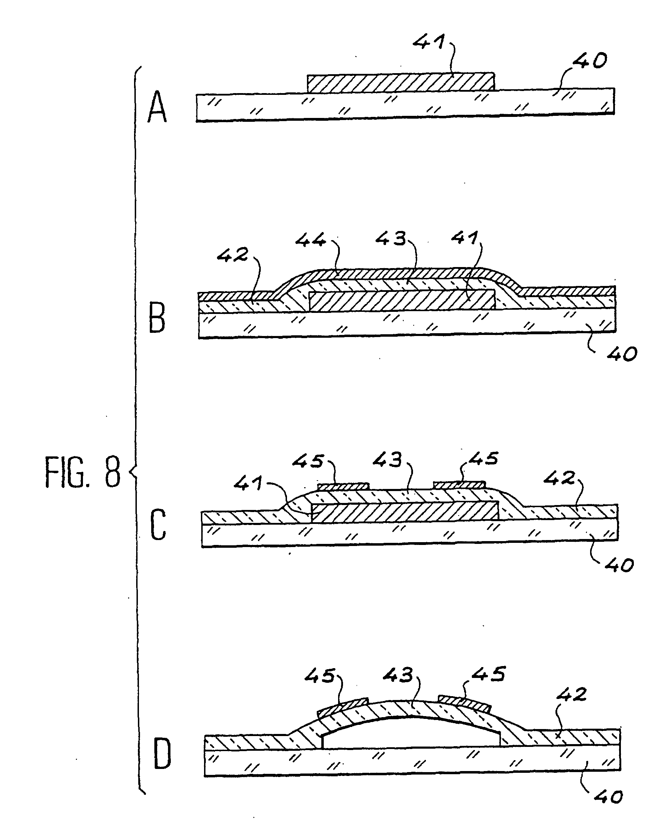

Une troisième variante du procédé selon l'invention, illustrée par les figures 8A à 8D, permet d'obtenir un microsystème à élément déformable plan et précontraint où l'on jouera sur une différence de température lors de la mise en forme des deux parties constituant le bilame.

Sur une surface d'un substrat 40, on dépose une couche sacrificielle que l'on grave pour obtenir une masse 41 d'épaisseur uniforme à l'emplacement du futur élément déformable (voir la figure 8A). On dépose ensuite une couche 42, par exemple en $SiO_2$ ou en $Si_3N_4$, qui recouvre la masse sacrificielle 41 et la surface apparente du substrat. On obtient ainsi une partie 43 de la couche 42, qui est rectiligne au-dessus de la masse sacrificielle 41 et naturellement contrainte (voir la figure 8B). On dépose ensuite une seconde couche 44 destinée à compléter le bilame. Cette couche 44 est déposée à une température supérieure à la température ambiante, ce qui conduira, à l'issue du procédé, à une déflexion naturelle de l'élément déformable.

Comme précédemment, la couche 44 est gravée pour obtenir des parties 45 (voir la figure 8C). De même, la couche 42 est gravée en fonction de la forme que l'on désire donner à l'élément déformable et pour ouvrir cet élément déformable afin de permettre l'élimination de la masse sacrificielle 41.

On obtient le microsystème illustré par la figure 8D où l'élément déformable 43 est naturellement défléchi par rapport à la surface du substrat 40. La valeur de la précontrainte dans la couche 42 doit être ajustée pour obtenir le flambage uniquement lorsque la structure bilame est activée.

A titre d'exemple, l'élément déformable peut être constitué d'une poutre de $Si_3N_4$ de 1 µm d'épaisseur et de 200 µm de longueur. La déflexion initiale (à la température ambiante) de la poutre peut être de 2 µm. Le reste de la structure bilame peut être en aluminium et avoir 1 µm d'épaisseur. La structure bascule pour une variation de température comprise entre 100 et 120°C. L'amplitude obtenue est de l'ordre de 5 µm alors que pour une variation de température allant de 0 à 100°C la déflexion est inférieure à 1 µm.

Les figures suivantes illustrent des exemples d'application de l'invention et qui peuvent être obtenus par les procédés décrits ci-dessus.

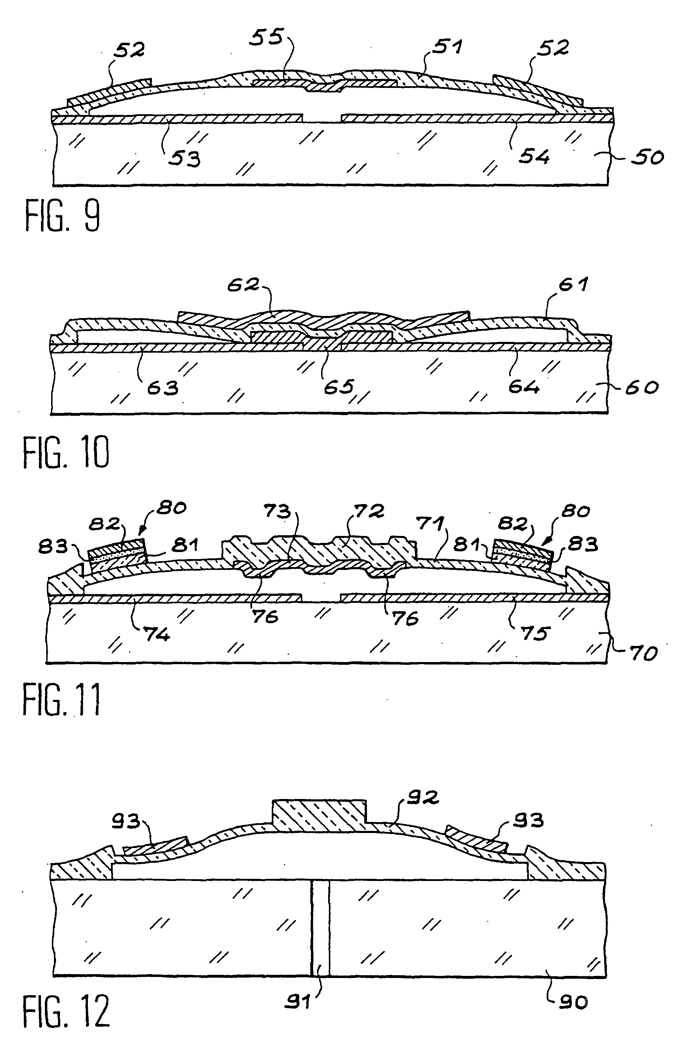

La figure 9 représente un micro-rupteur formé sur un substrat 50. Le bilame est constitué d'un élément déformable 51, par exemple en forme de poutre, et de deux parties 52. Au cours du procédé de fabrication du microsystème, des électrodes 53, 54 et 55 ont été prévues. Les électrodes 53 et 54 ont été réalisées avant le dépôt de la masse sacrificielle. L'électrode 55 est réalisée sur la masse sacrificielle, avant le dépôt des couches du bilame.

Il est aussi possible de concevoir un micro-rupteur normalement fermé comme le montre la figure 10. Le micro-rupteur a été formé sur un substrat 60. Le bilame est constitué d'un élément déformable 61 (poutre ou membrane) et d'une partie 62. Les électrodes 63 et 64 ont été réalisées avant le dépôt de la masse sacrificielle. L'électrode 65 est réalisée sur la masse sacrificielle, avant le dépôt des couches du bilame. L'état normalement fermé pour le micro-rupteur est obtenu en utilisant la troisième variante du procédé selon l'invention et en centrant la partie 62 sur l'élément déformable 61.

On comprend que lorsque le bilame des figures 9 et 10 bascule, il y a passage d'un état de fonctionnement donné vers un autre état de fonctionnement. Ainsi, pour la figure 9, le basculement du bilame permettra le passage de l'état ouvert (cas représenté à la figure 9) à l'état fermé par mise en contact de l'électrode 55 avec les électrodes 53 et 54. Le microsystème de la figure 10 fonctionne de façon inverse.

Afin d'avoir un bon contact électrique entre les électrodes lorsque le micro-rupteur est fermé, il est avantageux d'apporter les modifications représentées sur la figure 11. Cette figure représente un micro-rupteur normalement ouvert, formé sur un substrat 70 supportant des électrodes 74 et 75. L'élément déformable 71 est formé par une couche épaisse, localement amincie afin de rigidifier la partie centrale 72, qui est donc plus épaisse, au niveau de l'électrode 73 supportée par cette partie centrale. Ceci permet aussi de limiter l'influence de dilatation thermique induite par l'électrode 73.

Suivant les épaisseurs de dépôt des différentes couches, et suivant le procédé utilisé, il peut aussi être avantageux de localiser les zones de contact entre l'électrode 73 et les électrodes 74 et 75. Ceci peut être obtenu par une étape de planarisation de la couche sacrificielle ou, comme représenté sur la figure 11, en réalisant des déports 76 obtenus par photolithogravure de la couche sacrificielle.

Une autre amélioration possible consiste à utiliser différents matériaux pour réaliser l'autre partie du bilame, référencée 80 sur la figure 11. Les parties 80 peuvent comprendre une première couche 81 adjacente à l'élément déformable et de résistivité élevée (par exemple en TiN), servant d'élément chauffant. Une deuxième couche 82, superposée à la couche 81, ayant un coefficient de dilatation élevée, a un rôle thermomécanique. La couche 82 peut être en aluminium. Suivant les matériaux utilisés, il peut être nécessaire d'isoler les couches 81 et 82 par une fine couche de passivation 83.

La figure 12 représente, vue en coupe, une micro-valve constituée sur un substrat 90 percé d'un trou 91 faisant communiquer deux faces opposées du substrat. La micro-valve comporte une structure bilame comprenant un élément déformable 92 et une ou des parties 93. En fonction de la température induite dans le bilame, l'élément déformable ferme ou ouvre le trou 91.

## Revendications

1. Microsystème constitué sur un substrat (50/60/70/90) et servant à obtenir un basculement entre un premier état de fonctionnement et un deuxième état de fonctionnement grâce à un actionneur thermique à effet bilame, ledit actionneur comprenant un élément déformable (51,61,71,92) **caractérisé en ce que** ledit élément déformable est rattaché, par des extrémités opposées, au substrat de façon à présenter naturellement une déflexion sans contrainte par rapport à une surface du substrat qui lui est opposée, cette déflexion naturelle déterminant ledit premier état de fonctionnement, ledit deuxième état de fonctionnement étant provoqué par ledit actionneur thermique qui induit, sous l'effet d'une variation de température, une déformation de l'élément déformable (51,61,71,92) tendant à diminuer sa déflexion et le soumettant à une contrainte de compression qui entraîne son basculement par effet de flambage dans une direction opposée à sa déflexion naturelle.

2. Microsystème selon la revendication 1, **caractérisé en ce que** ledit premier état de fonctionnement correspond à une position de l'élément déformable (51) la plus éloignée de ladite surface du substrat (50), ledit deuxième état de fonctionnement correspondant à une position de l'élément déformable (51) la plus proche de ladite surface du substrat.

3. Microsystème selon la revendication 1, **caractérisé en ce que** ledit premier état de fonctionnement correspond à une position de l'élément déformable (61) la plus proche de ladite surface du substrat (60), ledit deuxième état de fonctionnement correspondant à une position de l'élément déformable (61) la plus éloignée de ladite surface du substrat (60).

4. Microsystème selon l'une quelconque des revendications 1 à 3, **caractérisé en ce que** l'élément déformable (71) présente une partie centrale (72) plus épaisse que sa partie périphérique.

5. Microsystème selon l'une quelconque des revendications 1 à 4, **caractérisé en ce que** le substrat (50,60,70,90) est en un matériau choisi parmi le verre et le silicium.

6. Microsystème selon l'une quelconque des revendications 1 à 5, **caractérisé en ce que** l'élément déformable (51,61,71,92) est en un matériau choisi parmi $Si_3N_4$ et $SiO_2$.

7. Microsystème, selon l'une quelconque des revendications 1 à 5, **caractérisé en ce que** l'actionneur thermique à effet bilame est constitué d'une couche en un matériau choisi parmi $Si_3N_4$ et $SiO_2$ associée à une couche d'aluminium.

8. Micro-rupteur constitué d'un microsystème selon l'une quelconque des revendications 1 à 7, un système d'électrodes (53,54,55) étant prévu dans le microsystème, sur la surface du substrat (50) et sur l'élément déformable (51), de façon à présenter une continuité électrique entre électrodes (53,54,55) dans l'un desdits états de fonctionnement et une absence de continuité électrique dans l'autre desdits états de fonctionnement.

9. Micro-rupteur selon la revendication 8, **caractérisé en ce que** des zones de contact localisées (76) sont prévues sur le système d'électrodes.

10. Micro-valve constituée d'un microsystème selon l'une quelconque des revendications 1 à 7, au moins un orifice de communication de fluide (91) étant prévu dans le microsystème de façon à être obturé dans l'un desdits états de fonctionnement et ouvert dans l'autre desdits états de fonctionnement.

11. Procédé de fabrication d'un microsystème tel que défini dans la revendication 1, **caractérisé en ce que** :

   - l'élément déformable (29,36,43) est obtenu par dépôt d'une couche (26,33,42) de matériau approprié sur ladite surface du substrat (20,30,40), la couche étant solidaire de ladite surface à l'exception d'une partie formant voûte au-dessus de ladite surface et constituant l'élément déformable,
   - des moyens (28,35,45), obtenus par dépôt, sont prévus pour être en contact intime avec ledit élément déformable (29,36,43) et constituer avec celui-ci ledit actionneur thermique à effet bilame.

12. Procédé selon la revendication 11, **caractérisé en ce que** la partie formant voûte est obtenue grâce au dépôt préalable, sur ladite surface du substrat (20,30,40), d'une masse sacrificielle (25,32,41) destinée à donner une forme définie audit élément déformable une fois que la masse sacrificielle aura été sacrifiée, la masse sacrificielle (25,32,41) étant prévue pour que, à l'issue du procédé, ledit élément déformable (29,36,43) présente naturellement une déflexion sans contrainte par rapport à ladite surface du substrat (20,30,40).

13. Procédé selon la revendication 12, **caractérisé en ce qu'**il comprend les étapes successives suivantes :

   - dépôt sur ladite surface du substrat (20) d'une couche de matériau sacrificiel (21),
   - obtention sur la couche de matériau sacrificiel (21), d'une masse (23) d'un matériau susceptible de fluer sans altérer le substrat (20) et le matériau sacrificiel (21),

   - fluage du matériau susceptible de fluer pour lui conférer une forme (24) complémentaire de la forme en voûte désirée pour l'élément déformable,
   - gravure de la couche de matériau sacrificiel (21) et du matériau qui a flué jusqu'à ne garder sur ladite surface du substrat que ladite masse sacrificielle (25) qui reproduit la forme que possédait le matériau qui a flué,
   - dépôt de la couche (26) destinée à fournir l'élément déformable (29),
   - dépôt des moyens (28) destinés à constituer, avec ledit élément déformable (29), ledit actionneur thermique,
   - élimination de la masse sacrificielle (25).

14. Procédé selon la revendication 13, **caractérisé en ce que** la masse (23) de matériau susceptible de fluer est obtenue par dépôt d'une couche de résine photosensible (22) sur la couche de matériau sacrificiel (21) et par gravure de cette couche de résine photosensible pour n'en garder que ladite masse (23) de matériau susceptible de fluer.

15. Procédé selon la revendication 12, **caractérisé en ce qu'**il comprend les étapes successives suivantes :

   - obtention sur ladite surface du substrat (30) d'une masse sacrificielle (32), à profil en escalier, et de formé sensiblement complémentaire de la forme en voûte désirée pour l'élément déformable,
   - dépôt de la couche (33) destinée à fournir l'élément déformable (36),
   - dépôt des moyens (35) destinés à constituer, avec ledit élément déformable (36), ledit actionneur thermique,
   - élimination de la masse sacrificielle (32).

16. Procédé selon la revendication 12, **caractérisé en ce qu'**il comprend les étapes successives suivantes :

   - obtention sur ladite surface du substrat (40) d'une masse (41) de matériau sacrificiel d'épaisseur uniforme à l'emplacement de l'élément déformable (43),
   - dépôt de la couche (42) destinée à fournir l'élément déformable, le dépôt étant réalisé de façon que la partie de cette couche recouvrant la masse (41) de matériau sacrificiel soit naturellement contrainte,
   - dépôt, sur la couche précédemment déposée, d'une couche (44) dans laquelle seront formés les moyens (45) destinés à constituer, avec ledit élément déformable (43), ledit actionneur thermique, ce dépôt étant réalisé à une température déterminée pour que, à l'issue du procédé, l'élément déformable (43) soit naturellement défléchi,

- gravure de la couche précédemment déposée pour former les moyens (45)destinés à constituer, avec ledit élément déformable, ledit actionneur thermique,
- élimination de la masse sacrificielle (41).

**17.** Procédé selon l'une quelconque des revendications 13 à 16, **caractérisé en ce qu'**il est prévu une étape consistant à ouvrir l'élément déformable (29,36,43) de façon que cette ouverture de l'élément déformable permette d'éliminer la masse sacrificielle (25/32,41).

## Claims

**1.** Microsystem assembled on a substrate (50, 60, 70, 90) which produces a shift between a first state of functioning and a second state of functioning by means of a bimetal-effect thermal sensor, the aforesaid sensor including a deformable element (51, 61, 71, 92), **characterized in that** said deformable element is attached, at opposite ends, to the substrate so that there is a natural deflection without stress with respect to a surface of the substrate opposite it, this natural deflection determining the first state of functioning, the aforesaid second state of functioning being caused by the aforesaid thermal sensor which, under the influence of temperature variation, induces a deformation of the deformable element (51, 61, 71, 92) which diminishes the deflection by subjecting it to a compressive force which shifts it in a direction opposite to its natural deflection by buckling.

**2.** Microsystem according to claim 1, **characterized in that** the aforesaid first state of functioning corresponds to a position of the deformable element (51) furthest from the aforesaid surface of the substrate (50), the aforesaid second state of functioning corresponding to a position of the deformable element (51) nearest to the aforesaid surface of the substrate.

**3.** Microsystem according to claim 1, **characterised in that** the aforesaid first state of functioning corresponds to a position of the deformable element (61) closest from the aforesaid surface of the substrate (60), the aforesaid second state of functioning corresponding to a position of the deformable element (61) furthest to the aforesaid surface of the substrate (60).

**4.** Microsystem according to any of claims 1 to 3, **characterised in that** the deformable element (71) has a central part (72) which is thicker than its peripheral part.

**5.** Microsystem according to any of claims 1 to 4, **characterised in that** the substrate (50,60,70,90) is a material chosen from glass and silicon.

**6.** Microsystem according to any of claims 1 to 5, **characterised in that** the deformable element (51,61,71,92)is made of a material chosen from $Si_3N_4$ and $SiO_2$.

**7.** Microsystem according to any of claims 1 to 5, **characterised in that** the thermal sensor with bimetal effect is made of a layer of a material chosen from $Si_3N_4$ and $SiO_2$ associated with an aluminium layer.

**8.** Microswitch made of a microsystem according to any of claims 1 to 7, a system of electrodes (53,54,55) being provided in the microsystem, on the surface of the substrate (50) and on the deformable element (51) so that there is electrical continuity between the electrodes (53,54,55) in one of the aforesaid states of functioning and an absence of electrical continuity in the other aforesaid states of functioning.

**9.** Microswitch according to claim 8, **characterised in that** localised contact zones (76) are included on the electrode system.

**10.** Microvalve composed of a microsystem according to any of claims 1 to 7, at least one fluid connection orifice (91) being included in the microsystem so that it is blocked in one of the states of functioning and open in the other of the aforesaid states of functioning.

**11.** Process for manufacturing a microsystem as defined in claim 1, **characterised in that**:

- the deformable element (29,35,43) is obtained by depositing of a layer (26,33,42) of appropriate material on the aforesaid surface of the substrate (20,30,40), the layer being linked to the aforesaid surface with the exception of a part which forms an arch above the aforesaid surface and which constitutes the deformable element,
- means (28,35,45), obtained by depositing, are in close contact with the aforesaid deformable element (29,35,43) and constitute, along with it, the aforesaid thermal sensor with bimetal effect.

**12.** Process according to claim 11, **characterised in that** the part which forms the arch is obtained by prior depositing, on the aforesaid surface of the substrate (20,30,40), of a sacrificial mass (25,32,41) to give a definite shape to the aforesaid deformable element once the sacrificial mass has been sacrificed, the sacrificial mass (25,32,41) being arranged so that, at the end of the process, the aforesaid deformable element (29,35,43) has a natural deflection without stress with respect to the aforesaid surface of the substrate (20,30,40).

13. Process according to claim 12, **characterised in that** it includes the following successive steps:

- depositing of a layer of sacrificial material (21) on the aforesaid surface of the substrate (20),

- obtaining on the layer of sacrificial material (21) a mass (23) of material which can flow without altering the substrate (20) and the sacrificial material (21),

- flowing of the material which can flow to give it a shape (24) which is complementary to the desired arch shape of the deformable element,

- etching of the layer of sacrificial material (21) and of the material which has flowed until there remains on the aforesaid surface of the substrate only the aforesaid sacrificial mass (25) which reproduces the shape of the material which flowed,

- depositing of the layer (26) which will provide the deformable element (29),

- depositing of the means (28) to form, with the aforesaid deformable element (29), the aforesaid thermal sensor,

- elimination of the sacrificial mass (25).

14. Process according to claim 13, **characterised in that** the mass (23) of material to flow is obtained by depositing of a layer of photosensitive resin (22) on the sacrificial material layer (21) and by etching of this layer of photosensitive resin so that only the aforesaid mass (23) of material which flows remains.

15. Process according to claim 12, **characterised in that** it includes the following successive steps:

- obtaining on the aforesaid surface of the substrate (30) a sacrificial mass (32), with a step profile, and of a shape essentially complementary to the shape of the arch desired for the deformable element,

- depositing of the layer (33) to form the deformable element (36),

- depositing of the means (35) to form, with the aforesaid deformable element (36), the aforesaid thermal sensor,

- elimination of the sacrificial mass (32).

16. Process according to claim 12, **characterised in that** it includes the following successive steps:

- obtaining on the aforesaid surface of the substrate (40) a mass (41) of sacrificial material of uniform thickness at the place of the deformable element (43),

- depositing of the layer (42) to provide the deformable element, the deposit being done so that the part of this layer which covers the mass (41) of sacrificial material is naturally under stress,

- depositing, on the previously deposited layer, of a layer (44) in which will be formed the means (45) to form, with the aforesaid deformable element (43), the aforesaid thermal sensor, this deposit being done at a determined temperature so that, at the end of the process, the deformable element (43) is naturally deflected,

- etching of the previously deposited layer to form the means (45), with the aforesaid deformable element, for the aforesaid thermal sensor,

- elimination of the sacrificial mass (41).

17. Process according to any of claims 3 to 16, **characterised in that** there is a step involving opening the deformable element (29,36,43) so that this opening of the deformable element allows for elimination of the sacrificial mass (25,32,41).

**Patentansprüche**

1. Mikrostruktur, ausgebildet auf einem Substrat (50,60,70,90), dazu dienend, durch ein Thermo-Wirkglied mit bimetallartigem Effekt ein Kippen zwischen einem ersten Betriebszustand und einem zweiten Betriebszustand zu erzielen, wobei das genannte Wirkglied ein verformbares Element (51,61,71,92) umfasst,
**dadurch gekennzeichnet,**
**dass** das genannte verformbare Element mit seinen entgegengesetzten Enden derart an dem Substrat befestigt ist, dass in Bezug auf eine ihm gegenüberstehende Fläche des Substrats ein natürlicher Ausschlag möglich ist, ohne Spannung, wobei dieser natürliche Ausschlag den genannten ersten Betriebszustand definiert, und der genannte zweite Betriebszustand durch das genannte Thermo-Wirkglied aufgrund einer Temperaturänderung herbeigeführt wird, die eine Verformung des verformbaren Elements (51,61,71,92) bewirkt, welche die Tendenz hat, seinen Ausschlag zu verringern und es einer Druckspannung zu unterziehen, die durch Knickeffekt sein Kippen in eine seinem natürlichen Ausschlag entgegengesetzte Richtung bewirkt.

2. Mikrostruktur nach Anspruch 1, **dadurch gekennzeichnet, dass** der genannte erste Betriebszustand einer Stellung entspricht, in der das verformbare Element (51) am weitesten von der genannten Oberfläche des Substrats (50) entfernt ist, und der genannte zweite Betriebszustand einer Stellung entspricht, in der das verformbare Element (51) sich am dichtesten bei der genannten Oberfläche des Substrats befindet.

3. Mikrostruktur nach Anspruch 1, **dadurch gekennzeichnet, dass** der genannte erste Betriebszustand einer Stellung entspricht, in der das verformbare Element (61) sich am dichtesten bei der genannten Oberfläche des Substrats (60) befindet, und der genannte zweite Betriebszustand einer Stellung entspricht, in der das verformbare Element (61) am weitesten von der genannten Oberfläche des Substrats (60) entfernt ist.

4. Mikrostruktur nach einem der Ansprüche 1 bis 3, **dadurch gekennzeichnet, dass** das verformbare Element (71) einen zentralen Teil (72) umfasst, der dicker ist als sein peripherer Teil.

5. Mikrostruktur nach einem der Ansprüche 1 bis 4, **dadurch gekennzeichnet, dass** das Substrat (50,60,70,90) aus einem Material ist, das ausgewählt wird zwischen Glas und Silicium.

6. Mikrostruktur nach einem der Ansprüche 1 bis 5, **dadurch gekennzeichnet, dass** das verformbare Element (51,61,71,92) aus einem Material ist, das ausgewählt wird zwischen $Si_3N_4$ und $SiO_2$.

7. Mikrostruktur nach einem der Ansprüche 1 bis 5, **dadurch gekennzeichnet, dass** das Thermo-Wirkglied mit bimetallartigem Effekt durch eine Schicht aus einem Material gebildet wird, das ausgewählt wird zwischen $Si_3N_4$ und $SiO_2$ in Verbindung mit einer Aluminiumschicht.

8. Mikroschalter, gebildet durch eine Mikrostruktur nach einem der Ansprüche 1 bis 7, wobei ein System von Elektroden (53,54,55) in der Mikrostruktur auf der Oberfläche des Substrats (50) und auf dem verformbaren Element (51) derart vorgesehen ist, dass in einem der genannten Betriebszustände zwischen den Elektroden (53,54,55) eine elektrische Kontinuität besteht, und in dem anderen der genannten Betriebszustände keine elektrische Kontinuität besteht.

9. Mikroschalter nach Anspruch 8, **dadurch gekennzeichnet, dass** auf dem Elektrodensystem lokalisierte Kontaktzonen (76) vorgesehen sind.

10. Mikroventil, gebildet durch eine Mikrostruktur nach einem der Ansprüche 1 bis 7, wobei wenigstens eine Fluidverbindungsöffnung (91) in der Mikrostruktur vorgesehen ist, die in einem der genannten Betriebszustände verschlossen ist und in dem anderen der genannten Betriebszustände geöffnet ist.

11. Verfahren zur Herstellung eines Mikrosystems wie definiert in Anspruch 1, **dadurch gekennzeichnet:**

   - **dass** man das verformbare Element (29,36,43) durch das Abscheiden einer Schicht (26,33,42) aus geeignetem Material auf der genannten Oberfläche des Substrats (20,30,40) erhält, wobei die Schicht fest mit der genannten Oberfläche verbunden ist, mit Ausnahme eines gewölbeartigen Teils über der genannten Oberfläche, der das verformbare Element bildet,
   - **dass** durch Abscheidung hergestellte Einrichtungen (28,35,45) vorgesehen sind, die einen engen Kontakt mit dem genannten verformbaren Element (29,36,43) haben und mit diesem zusammen das genannte Thermo-Wirkglied mit bimetallartigem Effekt bilden.

12. Verfahren nach Anspruch 11, **dadurch gekennzeichnet, dass** der gewölbeartige Teil hergestellt wird, indem man im Voraus auf der genannten Oberfläche des Substrats (20,30,40) eine Opfermasse (25,32,41) abscheidet, die dem verformbaren Element eine definitive Form verleiht, sobald die Opfermasse geopfert worden ist, wobei die Opfermasse (25,32,41) dazu dient, dass das genannte verformbare Element (29,36,43) am Ende des Verfahrens einen natürlichen Ausschlag aufweist, ohne Spannung in Bezug auf die genannte Oberfläche des Substrats (20,30,40).

13. Verfahren nach Anspruch 12, **dadurch gekennzeichnet, dass** es die folgenden Schritte umfasst:

   - Abscheiden einer Opfermaterialschicht (21) auf der genannten Oberfläche des Substrats (20),
   - Herstellen einer Masse (23) aus einem fließfähigen Material auf der Opfermaterialschicht (21), ohne das Substrat (20) und die Opferschicht (21) zu verändern,

- Zerfließen lassen des fließfähigen Materials, um ihm eine Form (24) zu verleihen, die zu der für das verformbare Element erwünschten gewölbeartigen Form komplementär ist,
- Ätzen der Opfermaterialschicht (21) und des zerflossenen Materials, sodass auf der genannten Oberfläche des Substrats nur die genannte Opfermasse (25) übrigbleibt, die die Form reproduziert, welche das zerflossene Material aufwies.
- Abscheiden der Schicht (26), dazu bestimmt, das verformbare Element (29) zu liefern,
- Abscheiden der Einrichtungen (28), die zusammen mit dem verformbaren Element (29) das genannte Thermo-Wirkglied bilden,
- Entfemen der Opfermasse (25).

14. Verfahren nach Anspruch 13, **dadurch gekennzeichnet, dass** die Masse (23) aus fließfähigem Material hergestellt wird durch das Abscheiden einer Photoresistschicht (22) auf der Opferschicht (21) und das derarüge Ätzen dieser Photoresistschicht, dass nur die genannte Masse (23) aus fließfähigem Material übrigbleibt.

15. Verfahren nach Anspruch 12, **dadurch gekennzeichnet, dass** es folgende aufeinanderfolgende Schritte umfasst:

- Herstellen einer Opfermasse (32) auf der genannten Oberfläche des Substrats (30), mit treppenförmigem Profil und einer Form, die im Wesentlichen komplementär ist zu der für das verformbare Element erwünschten gewölbeartigen Form,
- Abscheiden der Schicht (33), dazu bestimmt, das verformbare Element (36) zu liefern,
- Abscheiden der Einrichtungen (35), dazu bestimmt, mit dem verformbaren Element (36) das genannte Thermo-Wirkglied zu bilden,
- Entfernen der Opfermasse (32).

16. Verfahren nach Anspruch 12, **dadurch gekennzeichnet, dass** es folgende aufeinanderfolgende Schritte umfasst:

- Herstellen einer Opfermaterialmasse (42) von gleichmäßiger Dicke anstelle des verformbaren Elements (43) auf der genannten Oberfläche des Substrats (40),
- Abscheiden der das verformbare Element liefernden Schicht (42), wobei die Abscheidung derart realisiert wird, dass derjenige Teil dieser Schicht, der die Opfermaterialmasse (41) überdeckt, eine natürliche Spannung aufweist,
- Abscheiden, auf der vorhergehend abgeschiedenen Schicht, einer Schicht (44), aus der die Einrichtungen (45) gebildet werden, die dazu bestimmt sind, mit dem verformbaren Element (43) das genannte Thermo-Wirkglied zu bilden, wobei diese Abscheidung mit einer Temperatur durchgeführt wird, die so festgelegt ist, dass das verformbare Element (43) am Ende des Verfahrens eine natürliche Krümmung aufweist,
- Ätzen der vorhergehend abgeschiedenen Schicht, um die Einrichtungen (45) auszubilden, die mit dem verformbaren Element das genannte Thermo-Wirkglied bilden,
- Entfernen der Opfermasse (41).

17. Verfahren nach einem der Ansprüche 13 bis 16, **dadurch gekennzeichnet, dass** ein Schritt vorgesehen ist, der darin besteht, das verformbare Element (29,36,43) so zu öffnen, dass diese Öffnung des verformbaren Elements ermöglicht, die Opfermasse (25,32,41) zu entfernen.

FIG. 1

FIG. 2

FIG. 3

FIG. 4

FIG. 5

FIG. 6

FIG. 6

FIG. 7

A — 31, 30

B — 32, 30

C — 34, 32, 33, 30

D — 35, 36, 35, 33, 30

FIG. 8

FIG. 9

FIG. 10

FIG. 11

FIG. 12